# DEMANDE DE BREVET EUROPEEN

(11) **EP 4 557 382 A1**
(43) Date de publication de la demande: **21.05.2025**
(21) Numéro de dépôt: 23210983.5
(22) Date de dépôt: 20.11.2023
(51) Int. Cl.: H01L 31/042, H02S 20/32, H02S 40/22, H02S 30/20

(54) **ENSEMBLE POUR PANNEAU SOLAIRE ET PANNEAU SOLAIRE**

(71) Demandeur: Oksuz, Murat, 4100 Seraing (BE)
(72) Inventeur: Oksuz, Murat, 4100 Seraing (BE)
(74) Mandataire: Gevers Patents

(57) **Abrégé**

La présente invention concerne un ensemble pour panneau solaire (1) formé par une cellule solaire (2) étant couplée mécaniquement à un réflecteur (3) qui lui est adjacent. Elle concerne aussi un panneau solaire (1) muni d'un tel ensemble.

## Description

### Domaine technique

L'invention exposée dans le présent document concerne un ensemble pour panneau solaire et un panneau solaire comprenant cet ensemble.

### Art antérieur

Pour exploiter l'énergie du soleil, il est bien connu de nos jours d'utiliser des « panneaux solaires », aussi connus sous le nom de panneaux photovoltaïques.

Un tel panneau solaire permet en particulier de convertir le rayonnement solaire en énergie électrique. Il comprend un assemblage de « cellules solaires », aussi appelées cellules photovoltaïques, qui sont des composants électroniques aptes à réagir au rayonnement solaire par effet photoélectrique.

Au vu les enjeux environnementaux et climatiques actuels, l'énergie solaire joue un fondamental comme source d'énergie renouvelable pour notre société. À cette fin, l'amélioration du rendement des panneaux solaires est essentielle, et se met typiquement en oeuvre par le développant de semi-conducteurs toujours plus performant pour constituer les cellules solaires.

Les cellules solaires issues de tels développements sont cependant de plus en plus complexes à fabriquer, de sorte qu'une autre approche dans l'amélioration du rendement des panneaux solaires est souhaitée.

### Exposé de l'invention

Un objet de la présente invention est de fournir des moyens pour rendre un panneau solaire plus performant.

À cet effet, il est proposé un ensemble pour panneau solaire comprenant :
- une cellule solaire, et
- un réflecteur adjacent et couplé mécaniquement à la cellule solaire, s'étendant selon un plan formant un angle compris entre 50° et 85° avec la cellule solaire.

L'ensemble selon l'invention permet d'améliorer le rendement d'un panneau solaire auquel il est intégré. En effet, le réflecteur agencé de façon adjacente à la cellule solaire est orienté de façon à réfléchir sur la cellule solaire un rayonnement solaire qui passerait normalement à côté de cette cellule solaire. Le rayonnement solaire reçu par la cellule solaire est dès lors supérieur à ce qu'il serait sans le réflecteur, et la quantité d'énergie électrique qu'il produit est ainsi accrue. L'angle susdit a été choisi dans le but d'obtenir de bonnes performances à cet égard en considérant qu'une cellule solaire est généralement orientée vers le rayonnement solaire, idéalement perpendiculairement à celui-ci, ou à tout du moins en formant un angle de moins de 30° avec celui-ci.

L'inventeur a déterminé qu'un angle compris entre 65° et 70°, de préférence d'environ 67,5° était préféré. Cet angle tend à maximiser le rendement lorsque la cellule solaire est orientée perpendiculairement au rayonnement solaire. La valeur préférée susdite n'est pas limitative du cadre de l'invention, d'une part vu qu'une amélioration des performances du panneau solaire existe pour des angles entre 50° et 85°, et d'autre part vu que le panneau solaire n'est pas orienté exactement perpendiculairement au rayonnement à tout moment de la journée, l'angle entre le rayonnement solaire et le plan de la cellule solaire étant à prendre en compte pour évaluer en pratique les performances du panneau solaire tel qu'il est bien connu par un homme du métier.

L'approche de la présente invention se distingue avantageusement de l'art antérieur en ce qu'il est fourni des moyens essentiellement mécaniques compacts et couplés mécaniquement directement à la cellule et/ou au panneau solaire pour accroître les performance de conversion énergique d'un panneau solaire.

Dans le cadre du présent document, un « panneau solaire » correspond à un assemblage de cellules solaires connectées électriquement tel qu'il est connu d'un homme du métier. Toute partie de panneau solaire comprenant une pluralité de cellules solaires connectées électriquement peut donc aussi être assimilée à un panneau solaire au sens de ce document. L'usage de ce terme suppose, dans ce document, que les cellules solaires peuvent être connectées électriquement de façon à rendre le panneau solaire fonctionnel même si cet aspect n'est pas décrit en détails.

Dans le cadre du présent document, le terme « réflecteur » est utilisé pour faire référence à un objet permettant de modifier la trajectoire d'un rayonnement lumineux, typiquement solaire. En particulier, le réflecteur est utilisé dans le cadre de l'invention pour rediriger du rayonnement solaire qui ne devrait normalement pas interagir avec la cellule solaire vers la cellule solaire. Il s'agit typiquement d'un réflecteur optique. Tout type de réflecteur connu qui soit suffisamment rigide selon l'emplacement final du panneau solaire peut être utilisé. Il est par exemple formé d'une plaque en aluminium de 1,0 à 2,0 mm d'épaisseur.

Dans le cadre du présent document, la notion de « couplage mécanique » entre deux éléments fait référence à un maintien mécanique des positions de ces deux éléments l'un par rapport à l'autre. Ce terme inclut la possibilité d'une fixation directe entre ces deux éléments, mais également celle d'une fixation indirecte au moyen d'au moins un élément intermédiaire. Un couplage mécanique entre deux éléments n'exclut pas un possible mouvement relatif entre ces deux éléments.

En particulier, dans le cadre de l'invention, une rotation relative du réflecteur autour d'un axe de jonction entre celui-ci et la cellule solaire (ou, comme introduit ci-après, le cadre de support) est préférée pour ajuster l'orientation du réflecteur par rapport à la cellule et/ou le panneau solaires. Cette ajustement peut être fait de façon manuelle ou être piloté et/ou guidé par des moyens électromécaniques connectés au couplage mécanique.

Le couplage mécanique susdit peut par exemple être mis en oeuvre par une charnière, optionnellement agencée sur une structure encadrant la cellule et/ou le panneau solaires. De façon alternative, le réflecteur peut être totalement fixé par rapport à ces derniers, éventuellement par l'intermédiaire de la structure susdite. Comme le réflecteur est adjacent à la cellule solaire, le couplage mécanique se fait typiquement sans intermédiaire (par exemple, par fixation directe) ou, selon un mode de réalisation préféré, par l'intermédiaire d'un élément de jonction, comme la structure et/ou la charnière susdites, celui-ci étant typiquement de petite taille et servant à la jonction entre la cellule et/ou le panneau solaire et le réflecteur.

Les termes « adjacent et couplé mécaniquement à » peuvent être substitués par « adjoint à », éventuellement par l'intermédiaire d'un élément de jonction (tel que la structure susdite) et/ou une liaison pivot (telle que la charnière susdite).

Dans le cadre de ce document, tel qu'il est connu, l' « angle » entre deux plans de l'espace usuel correspond au plus petit angle entre les directions des vecteurs normaux respectifs à ces plans. Il s'agit donc d'un angle aigu ou droit. Comme le comprendra l'homme du métier, le réflecteur est typiquement orienté radialement extérieurement à partir de la cellule et/ou du panneau solaire. De cette façon, il ne surplombe pas la cellule et/ou le panneau solaire afin de ne pas faire obstacle au rayonnement solaire qui y est naturellement dirigé. L'angle de rotation qui amène physiquement le réflecteur sur la cellule et/ou sur le panneau solaire correspond donc de préférence, en pratique, à l'angle supplémentaire de l'angle susdit.

L'usage, dans ce document, du verbe « comprendre », de ses variantes, et de ses conjugaisons, pour introduire un élément n'exclut pas la présence d'autres éléments que ceux mentionnés. L'usage de l'article indéfini « un », « une », ou de l'article défini « le », « la » ou « l' », pour introduire un élément n'exclut pas la présence d'une pluralité de ces éléments.

Les termes « premier », « deuxième », « troisième », etc. sont, quant à eux, utilisés dans ce document essentiellement pour différencier différents éléments, et ce sans impliquer d'ordre entre ces éléments.

Selon un mode de réalisation de l'invention, l'ensemble comprend deux tels réflecteurs couplés mécaniquement à des côtés opposés de la cellule solaire. De préférence, la cellule solaire a une forme rectangulaire et les réflecteurs sont fixés, avec un degré de liberté rotationnel éventuel, sur deux côtés opposés, se faisant face de la cellule solaire.

Ce mode de réalisation permet avantageusement d'accroître la quantité de rayonnement solaire redirigé vers la cellule solaire par rapport à la présence d'un réflecteur unique. L'agencement des réflecteurs au niveau de deux côtés opposés de la cellule solaire permet d'adopter une disposition symétrique des réflecteurs et donc un même angle avec la cellule solaire, ce qui facilite l'orientation de la cellule solaire et/ou des réflecteurs selon le rayonnement solaire. Les côtés de la cellule solaire adjacents aux réflecteurs sont de préférence les côtés les plus longs de la cellule solaire, ce afin d'augmenter le rayonnement solaire redirigé vers la cellule solaire sans nécessiter un réflecteur qui s'étende perpendiculairement à la cellule solaire sur une longue distance et qui risquerait de faire de l'ombre sur la cellule solaire.

L'invention propose également un panneau solaire muni de l'ensemble selon l'invention, et de préférence comprenant une pluralité de tels ensembles.

Les modes de réalisation et les avantages de l'ensemble selon l'invention se transposent mutatis mutandis au présent panneau solaire.

L'ensemble pour panneau solaire peut être intégré de multiples façons dans un panneau solaire comme il est décrit ci-après. Des cellules solaires traditionnels d'un panneau solaire peuvent être remplacées par l'ensemble selon l'invention, et/ou un réflecteur de grande taille peut être adjoint à un panneau solaire de telle sorte que les cellules solaires en bord de panneau solaire et les portions voisines de ce réflecteur forment des ensembles selon l'invention. Cette adjonction peut en outre être réalisée de multiples façons comme il est décrit ci-après.

Selon un premier mode de réalisation, le panneau solaire est partitionné en une pluralité de zones qui sont :
- des premières zones occupées par des cellules solaires, et
- des deuxièmes zones vides de cellule solaire.
Comme le panneau solaire comprend une pluralité d'ensembles selon l'invention, plusieurs des cellules solaires sont des cellules solaires de tels ensembles et sont dès lors couplées mécaniquement à au moins un réflecteur.

Ce premier mode de réalisation est avantageux car il propose un panneau solaire dont au moins une cellule solaire est « absente » de sorte qu'elle laisse un emplacement vide de cellule solaire définissant une deuxième zone. Ce panneau solaire converti donc moins de rayonnement solaire en énergie électrique vu qu'il comprend moins de cellules solaires mais il est aussi plus facile et moins coûteux à produire au vu de la complexité technologique sous-jacente à la production des cellules solaires. Le manque en productivité du panneau solaire est compensé de façon avantageuse en prévoyant des cellules solaires d'ensembles de l'invention, qui sont donc couplées mécaniquement à des réflecteurs, typiquement de petites tailles pour ne pas causer d'ombres sur les cellules solaires voisines, ce à tout du moins pour une orientation adéquate du panneau solaire comme décrit ci-avant.

Pour optimiser le rendement du panneau solaire décrit, les cellules solaires peuvent appartenir chacune à un ensemble selon l'invention et donc être chacune couplées mécaniquement à au moins un réflecteur. De façon alternative, afin de simplifier la conception du panneau solaire, seule une partie des cellules solaires peuvent être couplées mécaniquement à un réflecteur formant ainsi un ensemble selon l'invention. Par exemple, elles peuvent être disposées en un nombre limité, par exemple une ou deux, de lignes ou de colonnes, ce qui facilite l'adjonction des réflecteurs, ceux-ci pouvant être formé d'une seule plaque de réflexion adjacente à plusieurs cellules solaires. Le nombre de cellules solaires qui appartiennent à un ensemble selon l'invention représente de préférence entre la tiers et la totalité du nombre de cellules solaires du panneau solaire, de préférence au moins la moitié de façon à compenser l'absence de cellules solaires dans les deuxièmes zones.

De préférence, chaque première zone est adjacente à une des deuxièmes zones. Ainsi, le panneau solaire comprend une répartition homogène des cellules solaires et permet une production d'électricité homogène sur le panneau solaire. Cette configuration permet aussi d'éviter un encombrement et des zones d'ombre éventuelles consécutives à un grand nombre de réflecteurs dans une même partie du panneau solaire. Elle facile aussi la mise en oeuvre de la réalisation suivante.

Selon une réalisation préférée du premier mode de réalisation, le réflecteur d'un ensemble dont la cellule solaire occupe une des premières zones surplombe une des deuxièmes zones adjacente à cette dernière. La majorité des réflecteurs, préférentiellement tous les réflecteurs, sont de préférence agencés de cette façon, à l'exception des réflecteurs éventuellement orientés vers l'extérieur du panneau solaire, sur le bord de celui-ci.

Avantageusement, les deuxièmes zones sont utilisées non seulement pour réduire la complexité et le coût de fabrication du panneau solaire, mais aussi et surtout pour permettre un agencement facile et homogène des réflecteurs au sein du panneau solaire, sans causer des zones d'ombre sur d'autres cellules solaires. En effet, comme un réflecteur est orienté radialement extérieurement à partir de la cellule solaire, il surplombe a fortiori la zone voisine à la première zone occupée par cette cellule solaire. Si cette zone voisine est également une première zone, la cellule solaire qui y est présente sera ombragée par le réflecteur, et ne pourra pas atteindre son plein rendement. Prévoir que cette zone voisine soit une deuxième zone permet d'éviter ce défaut tout en allégeant et simplifiant le panneau solaire.

De préférence, les premières et les deuxièmes zones d'un panneau solaire selon ledit premier mode de réalisation sont en nombres égaux ou égaux à 10% près, et de préférence réparties de façon homogène sur le panneau solaire. Ceci facilite l'implémentation de la réalisation préférée susdite ainsi que la configuration pour laquelle tout ou partie des réflecteurs surplombent une deuxième zone.

De préférence, les premières et les deuxièmes zones d'un panneau solaire selon ledit premier mode de réalisation sont agencées de façon régulière et/ou de façon alternée, par exemple en lignes, en colonnes ou en quinconce. Ceci permet d'exacerber les avantages susdits dans l'agencement et la proportion des cellules solaires et des deuxièmes zones. La réalisation pour laquelle les premières zones sont agencées en lignes ou en colonnes est préférée pour faciliter les connexions électriques entre les cellules solaires.

Selon un deuxième mode de réalisation, le panneau solaire est tel que les ensembles sont semblables et alignés. Les cellules solaires des ensembles selon l'invention forment une rangée continue. Les réflecteurs sont chacun formés d'une portion d'une même plaque de réflexion, dite « plaque principale de réflexion ».

En d'autres termes, ce deuxième mode de réalisation correspond au cas où une plaque de réflexion est adjacente et couplée mécaniquement à un panneau solaire. Celui-ci peut être traditionnel ou selon ledit premier mode de réalisation. Ce deuxième mode de réalisation présente l'avantage d'être plus simple à mettre en oeuvre et de permettre la redirection d'un rayonnement solaire directement sur un grand nombre de cellules solaires au moyen d'une plaque de réflexion de plus grande dimension sans nécessairement considérer une pluralité de réflecteurs de petite dimension.

Dans le cadre de ce document, le terme « plaque de réflexion » est utilisé de semblablement au terme « réflecteur », de sorte que les considérations au regard du réflecteur s'appliquent à la plaque de réflexion. Deux termes sont utilisés pour différentier plus facilement les réalisations pour lesquelles le réflecteur est adjoint à une cellule solaire de celles pour lesquelles il est adjoint de façon plus globale à un panneau solaire, et donc à plusieurs cellules solaires ensemble. La deuxième réalisation se recoupe de toute façon avec la première vu que tout ou partie d'une plaque de réflexion au voisinage direct d'une cellule solaire est considéré, dans ce document, comme définissant un réflecteur au sens de l'invention.

Une plaque de réflexion peut être constituée d'aluminium et/ou de plastique et/ou d'un matériau réfléchissant connu d'un homme du métier. Elle est prévue avec une épaisseur suffisamment petite pour ne pas alourdir le panneau solaire et suffisamment grande pour résister à des vents modérés ou autres phénomènes météorologiques. Une épaisseur de 1,0 à 2,0 mm est préférée.

De préférence, le panneau solaire selon ledit deuxième mode de réalisation comprend plusieurs rangées successives de cellules solaires semblables qui sont agencées continûment selon une forme rectangulaire ayant une longueur et une largeur plus petite ou égale à la longueur. En particulier, les cellules solaires sont agencées de façon matricielle et connue de l'art antérieur. Les rangées de cellules solaires qui suivent la rangée suscitée des cellules solaires des ensembles selon l'invention ne sont pas nécessairement des parties d'ensembles selon l'invention et peuvent être des cellules solaires traditionnelles, c'est-à-dire sans réflecteur qui leur sont adjoints.

Un cadre de support (ou plus simplement cadre) borde préférentiellement la forme rectangulaire selon laquelle les rangées de cellules solaires sont agencées. La plaque principale de réflexion est alors couplée mécaniquement à un côté du cadre de support, dit « côté principal ». Cette réalisation permet d'adjoindre très simplement la plaque principale de réflexion sur un des bords du panneau solaire en couplant ou fixant mécaniquement celle-ci sur ledit côté du cadre de support.

Le panneau solaire comprend de préférence deux telles plaques principales de réflexion respectivement couplées mécaniquement (et adjointes) à des côtés principaux opposés du cadre de support. Ainsi, plus de rayonnement solaire est dirigé vers les cellules solaires, ce qui accroît leur performance. Les plaques principales de réflexion sont positionnés sur des côtés opposés, permettant une configuration symétrique, avec un même angle par rapport au panneau solaire, en évitant des interférences entre elles, notamment si deux tels panneaux solaires sont placés côte à côte.

De préférence, le ou les côtés principaux du cadre de support correspondent à la longueur de la forme rectangulaire. Auquel cas, la ou les plaques principales de réflexion sont de préférence chacune dimensionnée semblablement à la forme rectangulaire et s'étendent chacune sur tout le côté principal du cadre de support auquel elle est couplée mécaniquement (et adjointe).

Le choix du côté principal du cadre de support correspondant à la longueur de la forme rectangulaire permet à la ou aux plaques principales de réflexion de s'étendre sur le plus long des côtés du cadre de support. Il est ainsi possible de diriger le rayonnement solaire sur un grand nombre de cellules solaires sans que les plaques principales de réflexion ne s'étendent radialement extérieurement trop loin du cadre de support, et donc du panneau solaire, minimisant l'encombrement et l'ombre éventuelle (selon l'orientation du panneau solaire) qu'elles induisent.

Par un « dimensionnement semblable », il est fait référence dans le cadre de ce document à un dimensionnement à 10% près de longueur de côté. L'avantage d'utiliser un dimensionnement semblable de la forme rectangulaire et des plaques principales de support est qu'elles sont susceptible d'être repliées l'une sur l'autre sans dépasser, ce qui est pratique pour ranger le panneau solaire, notamment s'il s'agit d'un panneau solaire portatif d'appoint. En pratique, les plaques principales de réflexion ont par exemple une longueur supérieure de 5,0 à 20 mm à la forme rectangulaire.

Le cadre de support étant rectangulaire, il comprend deux autres côtés, dits « côtés latéraux » et chacun correspondant à la largeur de la forme rectangulaire.

De préférence, une plaque de réflexion, appelée « plaque latérale de réflexion », est couplée de façon mécanique (et adjointe) à un des côtés latéraux. La plaque latérale de réflexion est de préférence dimensionnée semblablement à au moins la moitié de la forme rectangulaire et s'étend sur tout le côté latéral. De façon plus préférée, une telle plaque latérale de réflexion est adjointe à chacun desdits côtés latéraux. Cette réalisation est typiquement utilisée pour un panneau solaire isolé pour lequel il est possible de maximiser la quantité de rayonnement solaire dirigée sur les cellules solaires en utilisant trois ou quatre plaques de réflexion, chacune couplée mécaniquement (et adjointe) à un côté distinct du cadre de support.

L'inventeur a toutefois mis en évidence que la ou les plaques latérales de réflexion ne jouent pas un rôle essentiel dans l'amélioration des performances du panneau solaire dans le cas préféré où la longueur de la forme rectangulaire est supérieure ou égale au double de sa largeur. Dans un tel cas, il est plus simple et tout à fait suffisant de prévoir seulement les deux plaques principales de réflexion dimensionnées semblablement à la forme rectangulaire comme décrit ci-avant.

Le deuxième mode de réalisation de l'invention est en particulier avantageux pour des panneaux solaires isolés tels qu'un panneau solaire portatif d'appoint ou un panneau solaire isolé monté sur un suiveur solaire tel que connu d'un homme du métier. De tels panneaux sont préférés selon l'invention même s'il est tout à fait envisageable d'utiliser des panneaux solaires selon l'invention, en particulier selon ledit premier mode de réalisation, sur un toit d'une construction orientée de façon appropriée.

De préférence, chaque plaque de réflexion est couplée mécaniquement sur un côté du cadre de support via une liaison pivot entre ces éléments réalisée par exemple via une ou plusieurs charnières. Auquel cas, chaque plaque de réflexion est maintenue selon l'angle par des moyens de maintien amovibles. Ceux-ci sont par exemple réalisés par un cliquet ou un tendeur. Ce dernier présente l'avantage d'éviter que la plaque de réflexion ne soit maintenue selon l'angle par rapport au panneau solaire de façon trop rigide, ce qui pourrait engendrer des dommages à la liaison pivot, voire à l'ensemble du panneau solaire, en cas de vents ou autres phénomènes météorologiques. En outre, un tendeur est facile à placer et enlever. La plaque de réflexion peut ainsi être repliées sur les rangées de cellules solaires dans une configuration de rangement du panneau solaire. La longueur du tendeur est de préférence essentiellement définie par l'angle.

L'inventeur propose également dans le cadre de ce document une structure de support pour panneau solaire comprenant ledit cadre de support auquel est couplé mécaniquement une ou plusieurs plaques de réflexion comme il est décrit ci-avant, et un fond encadré par le cadre. Le « fond » est par exemple une grille ou une plaque métallique ou plastique ayant les dimensions du cadre de support. Cette structure de support permet avantageusement de supporter des rangées de cellules solaires (ou panneau solaire usuel) en les posant simplement sur le fond, dans le cadre de support. Ainsi, elles sont maintenues dans la structure, laquelle confère une performance améliorée au panneau solaire correspondant grâce à la ou aux plaques de réflexion.

Ces structures de support permettent un nettoyage, une réparation et/ou un remplacement plus aisé de panneaux solaires lorsque les cellules solaires sont endommagées et/ou si leur efficacité peut être améliorée. En effet, elles peuvent être placées définitivement sur un site, par exemple, sur un toit ou sur un suiveur solaire.

L'invention propose aussi une méthode de production d'énergie comprenant les étapes de fournir un panneau solaire selon l'invention, de placer et maintenir (de jour) les cellules solaires des ensembles (de préférence toutes les rangées de cellules solaires) selon une orientation qui soit sensiblement perpendiculaire à un rayonnement solaire.

Les modes de réalisation et les avantages afférant au panneau solaire selon l'invention se transposent mutatis mutandis à la présente méthode. En particulier, la méthode selon l'invention permet une production d'énergie plus performante à partir d'un rayonnement solaire. Le terme « sensiblement perpendiculairement » correspond de préférence à une orientation entre le plan d'extension du panneau solaire et l'axe du rayonnement solaire comprise entre 75° et 105°.

De préférence, l'étape de maintien susdite est réalisé de façon mécanique par un suiveur solaire et/ou manuelle en réorientant les cellules solaires toutes les deux à six heures, par exemple, trois fois par jour.

### Brève description des figures

D'autres caractéristiques et avantages de la présente invention apparaîtront à la lecture de la description détaillée qui suit pour la compréhension de laquelle on se reportera aux figures annexées parmi lesquelles :
- la figure 1 illustre une vue tridimensionnelle du dessus d'un panneau solaire selon ledit deuxième mode de réalisation de l'invention ;
- la figure 2 illustre une vue tridimensionnelle de l'arrière du panneau solaire de la figure 1 agencé sur des moyens mécanique d'orientation ;
- la figure 3 illustre une vue de côté de l'ensemble de la figure 2 dans une configuration repliée et portative ;
- la figure 4 illustre une section médiane du panneau solaire de la figure 1 ;
- la figure 5 illustre une vue tridimensionnelle du dessus d'un panneau solaire selon ledit premier mode de réalisation de l'invention ;
- la figure 6 illustre une vue de côté de panneaux solaires selon une autre réalisation de l'invention.

Les dessins de ces figures ne sont pas à l'échelle. Des éléments semblables sont en général dénotés par des références semblables dans les figures. Dans le cadre du présent document, les éléments identiques ou analogues peuvent porter les mêmes références. En outre, la présence de numéros ou lettres de référence aux dessins ne peut être considérée comme limitative, ce notamment lorsque ces numéros ou lettres sont indiqués dans les revendications.

### Description détaillée de modes de réalisation de l'invention

Cette partie du document présente une description détaillée de modes de réalisation préférés de la présente invention. Cette dernière est décrite avec des réalisations particulières et des références à des figures mais l'invention n'est pas limitée par celles-ci. En particulier, les dessins des figures décrites ci-dessous ne sont que schématiques et ne sont pas limitants. Les références L, l, L₁, l₁, L₂, l₂, α, β, γ, Z1 et Z2 représentées sur certains dessins correspondent à des marques ou des repères géométriques essentiellement utilisés pour quantifier et/ou visualiser des propriétés de modes de réalisation de l'invention.

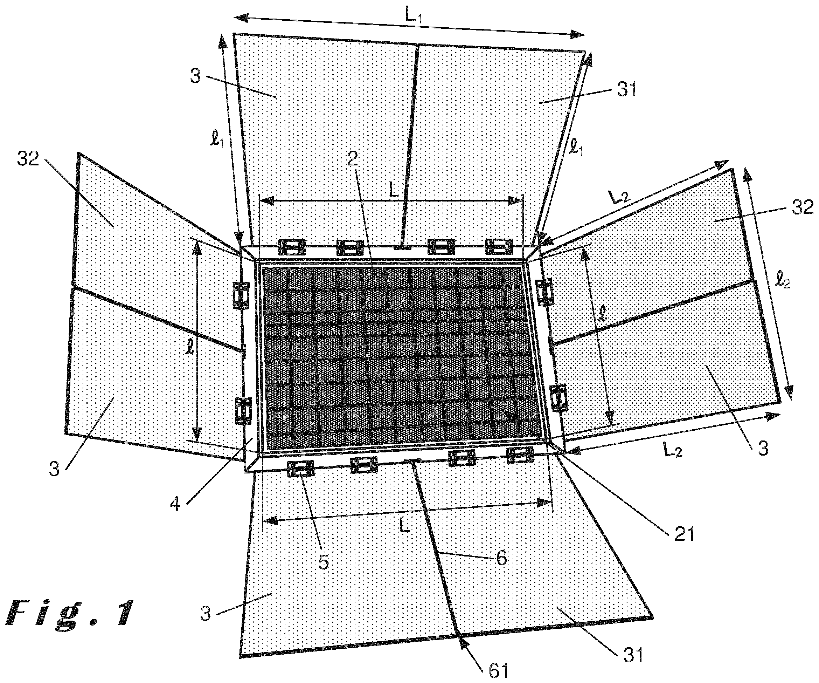

Les figures 1, 2 et 4 illustrent les vues susmentionnées d'un panneau solaire 1 portatif d'appoint selon un mode de réalisation préféré de l'invention dans une configuration d'utilisation.

Le panneau solaire comprend une pluralité de cellules solaires 21 disposées continûment en rangées successives selon une forme rectangulaire de longueur L et de largeur l ≤ L. Les cellules solaires 21 sont notamment reliées électriquement de façon connue d'un homme du métier. Le panneau solaire comprend un cadre de support 4 rectangulaire bordant les cellules solaires. Des plaques de réflexion 31, 32 sont couplées de façon mécanique au cadre de support 4 afin de diriger (et réfléchir) vers les cellules solaires tout ou partie du rayonnement solaire 9 qui les atteindrait.

Le couplage mécanique de chaque plaque de réflexion 31, 32 est réalisé de façon direct, sans intermédiaire, sur le cadre de support 4, au moyen d'une liaison pivot mise en oeuvre par des charnières 5 comme illustré. Chaque côté du cadre de support est associé à une plaque de réflexion 31, 32 dimensionnée de façon à s'étendre sur tout ou presque du côté correspondant. Des plaques de réflexion 31, 32 rectangulaires sont préférées, mais d'autres formes ou des coins arrondis sont envisageables sans se départir du cadre de l'invention.

Plus précisément, deux plaques principales de réflexion 31 semblables sont adjointes sur des côtés opposés du cadre de support 4 associés à la longueur L et deux plaques latérales de réflexion 32 semblables sont adjointes sur des côtés opposés du cadre de support 4 associés à la largeur l. Les deux plaques latérales de réflexion 32 procure un effet technique limité lorsque 2l ≤ L.

Les plaques principales de réflexion 31 sont d'une longueur L₁ ≈ L et d'une largeur l₁ ≈ l. Par exemple : 95% < L₁/L < 105% et 95% < l₁/l < 105%. Lorsque les plaques principales de réflexion 31 sont repliées sur le cadre de support 4 et les cellules solaires 21, elles couvrent totalement ou presque totalement ceux-ci sans dépasser, ce qui est pratique pour ranger le panneau solaire 1 mais aussi afin de protéger les cellules solaires 21 lors du rangement.

Les plaques latérales de réflexion 32 sont d'une longueur L₂ ≥ L/3 et d'une largeur ₗ₂ ≈ l. De façon préférée, L > L₂ et, de façon plus préférée L₂ ≈ L/2, pour limiter l'encombrement spatial vers l'extérieur des plaques latérales de réflexion 32. Par exemple : 95% < 2 L₂/L < 105% et 95% < l₂/l < 105%.

Chaque plaque de réflexion 31, 32 s'étend selon un plan formant un angle α compris entre 50° et 85° avec les cellules solaires 21. En d'autres termes, l'angle α est l'angle entre le plan d'une plaque de réflexion 31, 32 et le plan d'extension des cellules solaires 21 (ou, de façon équivalente, le plan dans lequel s'étend la forme rectangulaire). L'angle α est de préférence compris entre 65° et 70° pour diriger plus de rayonnement solaire 9 vers les cellules solaires 21 lorsqu'elles sont orientées perpendiculairement au rayonnement solaire 9. De préférence, l'angle α est le même pour chacune des plaques de réflexion 31, 32.

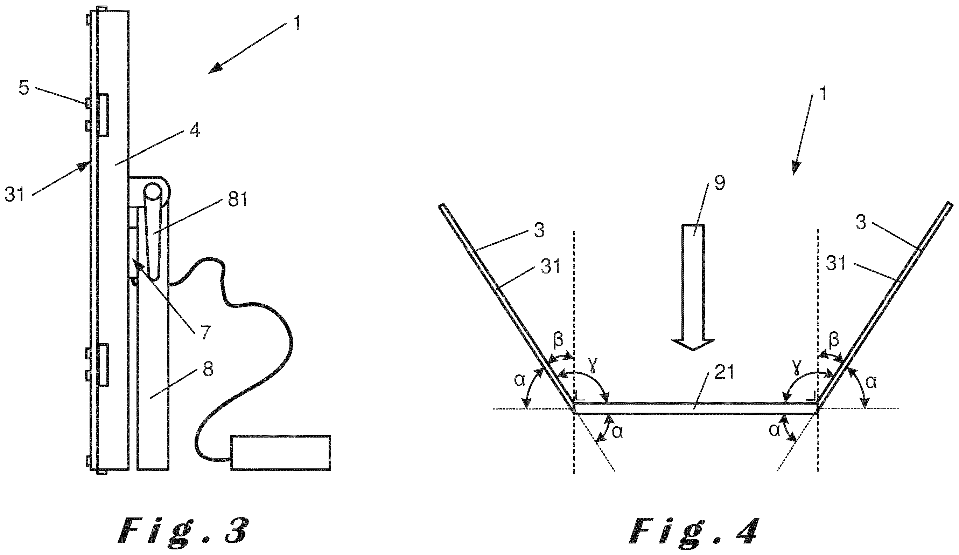

Comme il est illustré sur la section médiane de la figure 4, l'angle α est le plus petit angle entre les deux plans susdits (prolongés en lignes de points sur la figure). L'angle supplémentaire à l'angle α est noté γ = 180° - α. Il correspond à l'angle de rotation qui amène physiquement chaque plaque de réflexion 31, 32 sur les cellules solaires 21. L'angle γ s'écarte radialement vers l'extérieur des cellules solaires 21 d'un angle β = γ - 90° compris entre 5° et 40°, de préférence entre 20° et 25°.

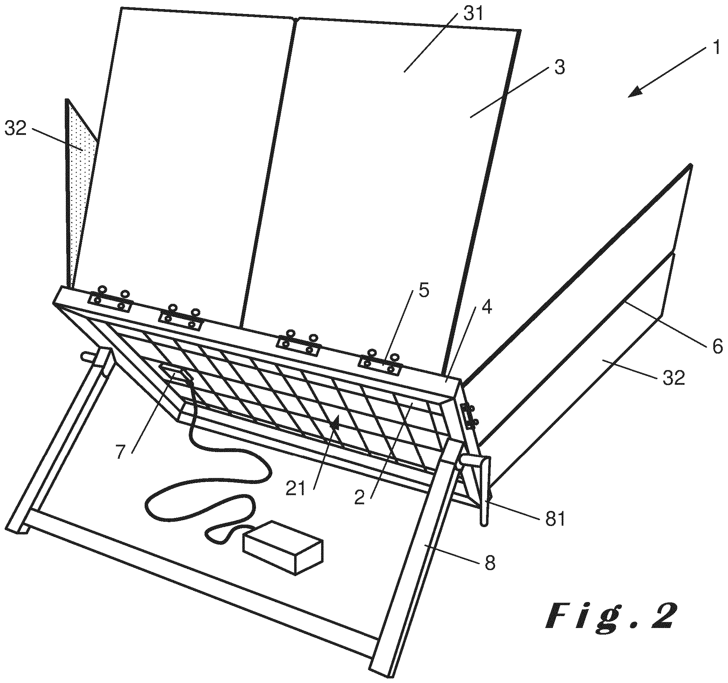

Les plaques de réflexion 31, 32 sont maintenues selon l'angle susdit par des moyens de maintien amovibles 6, typiquement des tendeurs comme illustrés aux figures 1 et 2. Une encoche 61 est prévue en sommet des plaques de réflexion 31, 32 pour y insérer les tendeurs et faciliter leur maintien selon l'angle α prescrit.

Comme il est représenté en figure 2, le cadre de support 4 est monté sur une structure mécanique d'orientation 8 du panneau solaire 1 qui permet par une manette de réglage 81 d'orienter les cellules solaires 21 perpendiculairement par rapport au rayonnement solaire 9 selon le moment de la journée. L'orientation et la direction spatiale du panneau solaire 1 peuvent ainsi être modifiée deux à trois fois par jour pour améliorer ses performances.

De façon connue les cellules solaires sont connectées électriquement à une sortie d'énergie électrique 7 qui peut être reliée à différents dispositifs appropriés par un câble électrique.

La structure mécanique d'orientation 8 est de préférence repliable comme il est visible en figures 2 et 3. En particulier, la figure 3 illustre le panneau solaire 1 portatif d'appoint des figures 1, 2 et 4 dans configuration de rangement. Tant les plaques de réflexion 31, 32 que la structure mécanique d'orientation 8 sont pliées selon un même plan, facilitant ainsi grandement le rangement du panneau solaire.

Les cellules solaires 2, 21 du panneau solaire 1 bordant le cadre de support 4 sont adjacentes et couplées mécaniquement à une des plaques de réflexion 31, 32 de telle sorte que la paire formée par chaque portion des plaques de réflexion 31, 32 adjacente à une telle cellule solaire 2, 21 et cette dernière forment ainsi un ensemble pour panneau solaire selon l'invention.

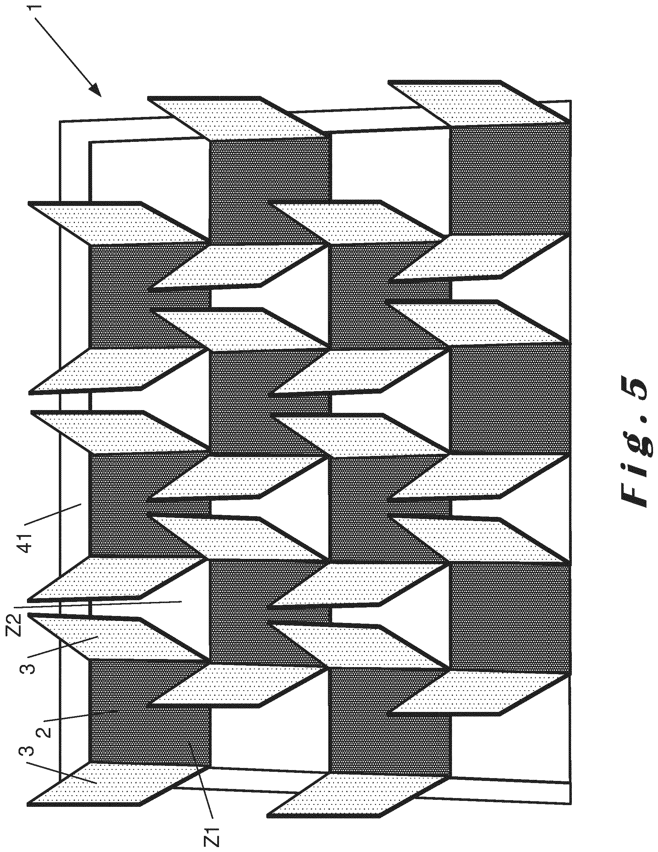

Une mise en oeuvre distincte des figures 1 à 4 de l'ensemble pour panneau solaire selon l'invention est illustrée en figure 5. Il s'agit d'un panneau solaire 1 qui est partitionné en des premières zones Z1 occupées par des cellules solaires 2 et des deuxièmes zones Z2 vides de cellule solaire. Chacune des cellules solaires 2 fait partie d'un ensemble selon l'invention en ce qu'au moins un réflecteur 3 lui est adjoint, et est donc adjacent et couplé mécaniquement à la cellule solaire 2.

Cette adjonction peut se faire par fixation directe ou plus préférentiellement par l'intermédiaire d'un cadre bordant la cellule solaire 2. Dans le cas illustré, deux tels réflecteurs 3 sont adjoints à partir de côtés opposés de la cellule solaire 2.

Les réflecteurs 3 des cellules solaires 2 sont orientés de façon semblables, en rangées, pour limiter les ombres éventuelles qu'ils peuvent causer. Ils sont de petites tailles par exemple, entre 25% et 100% de la surface d'une cellule solaire, de préférence environ 50%. Chacun des réflecteurs s'étend selon un plan formant un angle α compris entre 50° et 85° avec le plan du panneau solaire 1 dans lequel les cellules solaires 2 sont agencées.

De façon avantageuse, chaque première zone Z1 est adjacente à au moins une deuxième zone Z2 de telle sorte que le réflecteur 3 d'une cellule solaire 2 d'une première zone Z1 surplombe une deuxième zone Z2 adjacente qui lui est adjacente. Les premières et deuxièmes zones sont réparties en alternance sur le panneau solaire 1, en quinconce dans l'exemple de la figure 5, celle-ci n'étant pas limitative de la portée de l'invention.

Le panneau solaire 1 peut être bordé par un cadre 41 de façon connue. Les réflecteurs 3 surplombant le cadre peuvent être omis lorsque l'emplacement final du panneau solaire 1 ne permet pas leur présence, faute de place latérale.

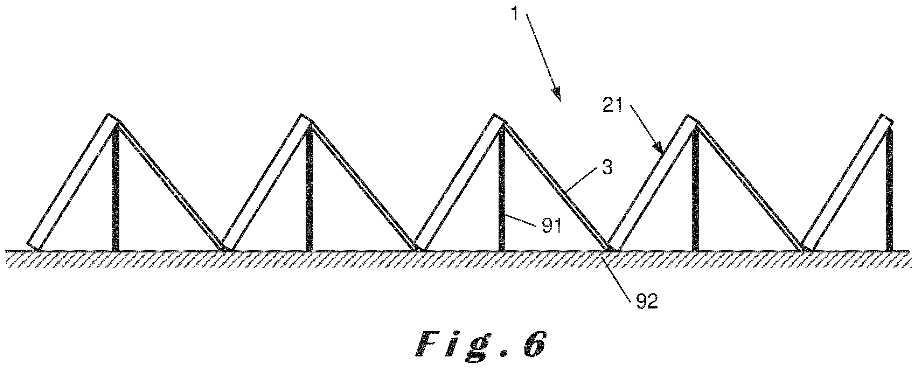

Une autre réalisation de la présente invention est illustrée en figure 6. Il est avantageusement proposé d'exploiter l'invention dans le cadre d'un parc ou d'une centrale de panneaux solaires traditionnels. Par exemple, des panneaux solaires comprenant des cellules solaires 21 sont posés sur un sol 92 et orientés face à un rayonnement solaire en étant supportés par des structures 91 tel qu'il est connu. Dans un tel cas, l'espace entre les panneaux solaires est habituellement perdu. Il est proposé dans le cadre de l'invention d'exploiter cet espace pour y positionner des réflecteurs 3 (ou plaques de réflexion), de telle sorte que tout ou partie des panneaux solaires du parc ou de la centrale deviennent selon l'invention. Dans ce cas, les réflecteurs 3 sont de préférence fixés en extrémités de panneaux solaires, même si l'angle α qui s'ensuit ne maximise pas les performances des panneaux solaires. En effet, en fixant un réflecteur 3 au sommet d'un panneau solaire d'une part, et en pied du panneau solaire derrière d'autre part, le réflecteur 3 est fixé de façon suffisamment stable pour résister au vent, tout en stabilisant l'ensemble du parc ou de la centrale solaire. Les réflecteurs 3 sont de dimensions adaptées à cette usage et prévues pour occuper tous l'espace disponibles entre les panneaux solaires de façon à améliorer au mieux leurs performances.

En d'autres termes, la présente invention prévoit un parc ou une centrale solaire comprenant une séquence de panneaux solaires alignés successivement l'un derrière l'autre, orientés fixement au moins partiellement selon une direction verticale, chaque panneaux solaires 1 au moins deuxième dans la séquence étant selon le deuxième mode de réalisation, et ayant une plaque principale de réflexion 31 (ou de façon équivalente un réflecteur) s'étendant d'un pied de ce panneau solaire 1 jusqu'à un sommet du panneau solaire précédant dans la séquence. Le pied et le sommet sont définis de part l'orientation verticale des panneaux solaires tel qu'il est connu de l'homme du métier.

En résumé, l'invention concerne un ensemble pour panneau solaire 1 formé par une cellule solaire 2 étant couplée mécaniquement à un réflecteur 3 qui lui est adjacent. Elle concerne aussi un panneau solaire 1 muni d'un tel ensemble.

La présente invention a été décrite ci-dessus en relation avec des modes de réalisations spécifiques, qui ont une valeur purement illustrative et ne doivent pas être considérés comme limitatifs. Il apparaîtra directement pour l'homme du métier que l'invention n'est pas limitée aux exemples illustrés ou décrits ci-dessus, et que sa portée est plus largement définie par les revendications ci-après introduites.

## Revendications

1. Ensemble pour panneau solaire (1) comprenant :
- une cellule solaire (2), et
- un réflecteur (3) adjacent et couplé mécaniquement à la cellule solaire (2), et s'étendant selon un plan formant un angle (α) compris entre 50° et 85° avec la cellule solaire (2).

2. Ensemble selon la revendication 1, comprenant deux tels réflecteurs (3) couplés mécaniquement à des côtés opposés de la cellule solaire (2).

3. Panneau solaire (1) comprenant une pluralité d'ensembles selon la revendication 1 ou 2.

4. Panneau solaire (1) selon la revendication 3, partitionné en des premières zones (Z1) occupées par des cellules solaires (2, 21) et des deuxièmes zones (Z2) vides de cellule solaire (2, 21).

5. Panneau solaire (1) selon la revendication 4, dans lequel le réflecteur (3) d'un ensemble dont la cellule solaire (2) occupe une des premières zones (Z1) surplombe une des deuxièmes zones (Z2) adjacente à cette dernière.

6. Panneau solaire (1) selon la revendication 4 ou 5, dans lequel les premières (Z1) et deuxièmes (Z2) zones sont agencées de façon régulière et alternée, de préférence en lignes, en colonnes ou en quinconce.

7. Panneau solaire (1) selon la revendication 3, dans lequel les ensembles sont semblables et alignés, les cellules solaires (2) formant une rangée continue et les réflecteurs (3) étant chacun formés d'une portion d'une même plaque principale de réflexion (31).

8. Panneau solaire (1) selon la revendication 7, comprenant plusieurs rangées successives de cellules solaires (2, 21) semblables agencées continûment selon une forme rectangulaire ayant une longueur (L) et une largeur (l) plus petite ou égale à la longueur (L), et bordée d'un cadre de support (4), la plaque principale de réflexion (31), étant couplée mécaniquement à un côté principal du cadre de support (4).

9. Panneau solaire (1) selon la revendication 8, comprenant une paire de telles plaques principales de réflexion (31) respectivement couplées mécaniquement à des côtés principaux opposés du cadre de support (4).

10. Panneau solaire (1) selon la revendication 8 ou 9, dans lequel le ou les côtés principaux du cadre de support (4) sont associés à la longueur (L) de la forme rectangulaire, et dans lequel la ou les plaques principales de réflexion (31) sont chacune dimensionnée semblablement à la forme rectangulaire et s'étendent chacune sur tout le côté principal auquel elle est couplée mécaniquement.

11. Panneau solaire (1) selon l'une quelconque des revendications 8 à 10, dans lequel un côté latéral du cadre de support (4) associé à la largeur (l) de la forme rectangulaire est couplé mécaniquement avec une plaque latérale de réflexion (32) dimensionnée semblablement à au moins la moitié de la forme rectangulaire et s'étendant sur tout le côté latéral.

12. Panneau solaire (1) selon l'une quelconque des revendications 8 à 11, consistant en un panneau solaire portatif d'appoint, dans lequel chaque plaque de réflexion (31, 32) est fixée sur un côté du cadre de support (4) par l'intermédiaire d'une liaison pivot (5), et maintenue selon l'angle par des moyens de maintien amovibles (6), de sorte que les plaques de réflexion (31, 32) puissent être repliées sur les rangées de cellules solaires (2, 21) dans une configuration de rangement du panneau solaire (1).

13. Parc ou centrale solaire comprenant une séquence de panneaux solaires alignés successivement l'un derrière l'autre, et orientés fixement au moins partiellement selon une direction verticale, chaque panneaux solaires (1) au moins deuxième dans la séquence étant selon la revendication 7 ou 8, et ayant une plaque principale de réflexion (31) s'étendant d'un pied de ce panneau solaire (1) jusqu'à un sommet du panneau solaire précédant dans la séquence.

14. Méthode de production d'énergie comprenant l'étape de fournir un panneau solaire (1) selon l'une quelconque des revendications 3 à 12, et l'étape de placer et maintenir de jour les cellules solaires (2) des ensembles selon une orientation sensiblement perpendiculairement à un rayonnement solaire (9).

15. Méthode selon la revendication 14, dans laquelle l'étape de maintien est réalisé mécaniquement par un suiveur solaire ou manuellement en réorientant les cellules solaires (2) toutes les deux à six heures.
